# EUROPÄISCHE PATENTSCHRIFT

(11) **EP 1 182 762 B1**
(45) Veröffentlichungstag und Bekanntmachung des Hinweises auf die Patenterteilung: **13.01.2010**
(21) Anmeldenummer: 01118960.2
(22) Anmeldetag: 04.08.2001
(51) Int. Cl.: H02H 7/08, G05B 9/03

(54) **Elektrisches Arbeitsgerät sowie Verfahren zu dessen Betreiben**
Electrical tool and method of its use
Outil électrique et procédé pour son utilisation

(30) Priorität: 24.08.2000 DE 10041607
(43) Veröffentlichungstag der Anmeldung: 27.02.2002
(73) Patentinhaber: Schneider Electric Motion Deutschland GmbH & Co. KG, 77933 Lahr (DE)
(72) Erfinder: Moddemann, Jörg, 77749 Hohberg (DE)
(74) Vertreter: Maucher, Wolfgang

(56) Entgegenhaltungen:
- US-A- 5 446 354

## Beschreibung

Die Erfindung bezieht sich auf ein Verfahren zum Betreiben eines elektrischen Arbeitsgerätes nach dem Obergegriff von Anspruch 1,

Des weiteren betrifft die Erfindung ein elektrisches Arbeitsgerät, insbesondere elektromotorischer Antriebt nach dem Oberbegriff von Anspruch 6.

Nach der EN 954-1 "Sicherheit von Maschinen - Sicherheitsbezogener Teil von Steuereungen" werden elektrische Arbeitsgeräte in Abhängigkeit von dem Gefahrenpotenzial, das von dem Arbeitsgerät ausgeht, in verschiedene Gefahrenklassen oder Kategorien eingeteilt. In dieser Norm ist auch die geforderte Wirksamkeit von Schutzmaßnahmen im Einzelnen geregelt. Es werden fünf Kategorien B, 1, 2, 3 und 4 unterschieden, von denen die Kategorie vier die höchsten Anforderungen an die Schutzmaßnahmen stellt. Die vorliegende Erfindung bezieht sich vor allem auf die Kategorie drei gemäß EN 954-1, das heißt auf Anwendungen, bei denen schwere irreversible Verletzungen häufig möglich sind, deren Gefahrenabwendung unter bestimmten Bedingungen möglich ist. Bei dieser Kategorie darf ein einzelner Fehler nicht zu einem Versagen der Sicherheitsfunktion führen.

Aus DE 30 29 851 C2 kennt man bereits ein elektrisches Gerät der eingangs genannten Art, bei der die Zwischenkreisspannung aufweisenden Ausgangsanschlüsse des am Wechselstromnetz angeschlossenen Gleichrichters über Sicherungselemente mit den beiden Eingangsanschlüssen beziehungsweise Polen der Brückenschaltung verbunden sind. Die Brückenschaltung weist drei Halbbrücken auf, deren Ausgangsanschlüsse mit den Wicklungen eines Elektromotors verbunden sind. Jede der Halbbrücken hat jeweils zwei Brückenzweige, von denen der eine den ersten Ausgangsanschluß der Halbbrücke mit dem einen Pol des Zwischenkreises und der andere den zweiten Ausgangsanschluß der Halbbrücke mit dem anderen Pol des Zwischenkreises verbindet. In den Brückenzweigen ist als Halbleiterschalter jeweils ein Thyristor angeordnet, dessen Steuereingang über eine Ansteuerschaltung mit einer Steuereinrichtung verbunden ist. Mittels der Steuereinrichtung werden an die Steuereingänge der Thyristoren Steuersignale für eine Pulsweitenmodulation derart angelegt, daß die an den Ausgangsanschlüssen der drei Halbbrücken angeschlossenen Motorwicklungen ein umlaufendes magnetisches Drehfeld erzeugen. Dabei werden die Thyristoren der einzelnen Halbbrücken jeweils so angesteuert, daß jeweils eine der beiden Brückenzweige der Halbbrücke leitend ist, während der jeweils andere Brückenzweig gesperrt ist.

Die Steuereinrichtung ist redundant ausgebildet und weist zwei Mikrorechner auf, von denen der eine die drei mit dem einen Pol der Zwischenkreisspannung verbundenen Thyristoren und der andere die drei mit dem anderen Pol der Zwischenkreisspannung verbundenen Thyristoren der Brückenschaltung ansteuert. Die beiden Mikrorechner sind über eine bidirektionale Datenleitung miteinander verbunden und überwachen sich gegenseitig, indem in jedem der Mikrorechner nach gegenseitigem Datenaustausch ein Ergebnisvergleich durchgeführt wird. Nach Angabe der Patentschrift führt jeder Ausfall eines Thyristors bereits nach kurzer Zeit zu einem Kurzschluß und damit zum Ansprechen der Sicherungselemente. Dadurch wird der an der Brückenschaltung angeschlossene Elektromotor abgeschaltet. Ungünstig ist dabei jedoch, daß das Abschalten des Elektromotors die ordnungsgemäße Funktion der Sicherungselemente voraussetzt. Bei einem Defekt an den Sicherungselementen kann es daher zu einem gefährlichen Betriebszustand des Elektromotors kommen.

Aus der DE 44 41 070 C2 kennt man auch bereits ein Arbeitsgerät mit einem elektrischen Verbraucher, der über eine elektronische Sicherheitsschaltung angesteuert wird. Die Sicherheitsschaltung ist redundant ausgebildet und weist zwei Rechnereinheiten auf, die jeweils einen mit einer Lichtschranke zur Überwachung eines im Bereich des elektrischen Verbrauchers befindlichen Schutzfeldes verbundenen Steuereingang haben. Die Rechnereinheiten sind über Signalleitungen jeweils mit Eingängen einer Ansteuerschaltung verbunden, die zwei Halbleiterschalter aufweist, mittels denen ein Steuerausgang der Ansteuerschaltung wechselweise mit einer Hilfsspannungsquelle oder mit Massepotential verbindbar ist. Dabei wird der elektrische Verbraucher nur dann eingeschaltet, wenn die Steuereingänge beider Ansteuerschaltungen aktiv sind.

Zur Überprüfung der Funktion der Halbleiterschalter weisen die Ansteuerschaltungen Rückleseleitungen auf, die mit Rückleseeingängen der Rechnereinheiten verbunden sind. Mittels der Rechnereinheiten werden jeweils über die Signalleitungen Testimpulse an die Steuerausgänge der Ansteuerschaltungen ausgegeben und dann über die Rückleseeingänge zurückgelesen. Wird dabei ein Fehler festgestellt, werden zumindest die noch funktionsfähigen Halbleiterschalter von den Rechnereinheiten geöffnet. Die Sicherheitsschaltung hat jedoch den Nachteil, daß der Betrieb des elektrischen Verbrauchers durch das Anlegen der Testimpulse gestört werden kann, da der Verbraucher während der Testphase kurzzeitig abgeschaltet wird.

Es besteht deshalb die Aufgabe, ein Verfahren und eine Vorrichtung der eingangs genannten Art zu schaffen, die eine sichere Abschaltung des elektrischen Verbrauchers ermöglicht.

Diese Aufgabe für ein Verfahren der eingangs genannten Art wird erfindungsgemäß durch ein Verfahren gemäß Anspruch 1 gelöst.

Durch getrennte Abschaltung der Hilfsversorgungsspannungen der Ansteuerschaltungen für die "oberen" und "unteren" Brückenzweige ergibt sich eine zweikanalige, unabhängige Abschaltung des elektromotorischen Antriebs. Da die Testabschaltung eine zyklische Überprüfung der Abschaltfunktion des elektrischen Verbrauchers ermöglicht, wird auch bei Verwendung kostengünstiger Halbleiterbauelemente zum Abschalten der Hilfsversorgungsspannung und/oder zum Ansteuern der Halbleiterschalter der Brückenschaltung eine sichere Not-Aus-Funktion ermöglicht.

Bei einer besonders vorteilhaften Ausführungsform der Erfindung wird die Testabschaltung während einer Nichtansteuerungsphase des in dem abzuschaltenden Brückenzweig angeordneten Halbleiterschalters durchgeführt. Dadurch ist es möglich ist, einerseits die Ansteuerschaltungen und andererseits aber auch das Abschalten der Hilfsversorgungsspannungen zu testen, ohne dadurch den Betrieb des elektrischen Verbrauchers zu beeinträchtigen. Die Überprüfung der Abschaltfunktion der Hilfsversorgungsspannung und der Ansteuerschaltungen kann somit für den Benutzer des elektrischen Arbeitsgeräts unbemerkt im Hintergrund erfolgen, was einen störungsfreien Betrieb des elektromotorischen Antriebs ermöglicht.

Vorteilhaft ist, wenn bei an demselben Pol der Zwischenkreisspannung angeschlossenen Brückenzweigen die Testabschaltung der an den Ansteuerschaltungen der in den Brückenzweigen angeordneten Halbleiterschalter anliegenden Hilfsversorgungsspannungen gleichzeitig durchgeführt wird. Die Testabschaltung der Hilfsversorgungsspannungen für die Ansteuerschaltungen der am Pluspol der Zwischenkreisspannung angeschlossenen Brückenzweige kann also mittels eines einzigen Halbleiterschaltelements für diese Brückenzweige gemeinsam durchgeführt werden. Entsprechend kann mittels eines weiteren Halbleiterschaltelements die Testabschaltung der Hilfsversorgungsspannungen für die Ansteuerschaltungen der am Minuspol der Zwischenkreisspannung angeschlossenen Brückenzweige gemeinsam erfolgen. Dabei erfolgt die Testabschaltung jeweils dann, wenn alle Halbleiterschalter, die an dem betreffenden Pol der Zwischenkreisspannung angeschlossen sind, gleichzeitig nicht angesteuert werden, das heißt wenn sämtliche Halbleiterschalter, die an dem anderen Pol der Zwischenkreisspannung angeschlossen sind, angesteuert werden.

Bei einer vorteilhaften Ausführungsform des Verfahrens ist vorgesehen, daß zur Synchronisation der Testabschaltungen der an den Ansteuerschaltungen anliegenden Hilfsversorgungsspannungen mit den an die Halbleiterschalter angelegten Steuersignalen der zeitliche Verlauf der Stromaufnahme wenigstens einer Ansteuerschaltung gemessen und mit einem Schwellwert verglichen wird. Dadurch kann eine Synchronisationsleitung zwischen der zur Erzeugung der Steuersignale vorgesehenen Steuereinrichtung und einer die Testabschaltung der an den Ansteuerschaltungen anliegenden Hilfsversorgungsspannungen steuernden Abschaltsteuereinrichtung eingespart werden.

Bei einer zweckmäßigen Ausgestaltung der Erfindung ist vorgesehen, daß die Steuerung der Testabschaltungen mittels eines Mikrocomputers erfolgt und daß vorzugsweise für jeden Halbleiterschalter oder für jede Gruppe von Halbleiterschaltern, bei den die Testabschaltung gleichzeitig durchgeführt wird, jeweils ein eigener Mikrocomputer vorgesehen ist, und daß sich die Mikrocomputer gegebenenfalls gegenseitig überwachen, wobei beim Auftreten eines Fehlers zumindest die an den Ansteuerschaltungen der an einem der Pole der Zwischenkreisspannung angeschlossenen Brückenzweige anliegenden Hilfsversorgungsspannungen abgeschaltet werden. Dadurch kann die Zuverlässigkeit der Abschaltfunktion für den elektrischen Verbraucher zusätzlich erhöht werden.

Die vorstehend genannte Aufgabe für ein elektrisches Arbeitsgerät der eingangs genannten Art, wird erfindungsgemäß durch eine Vorrichtung gemäß Anspruch 6 gelöst.

In vorteilhafter Weise ermöglicht die Kombination aus der Meßeinrichtung und der Abschalteinrichtungen eine überwachte Testabschaltung der an der Ansteuerschaltung der einzelnen Halbleiterschalter jeweils anliegenden Hilfsversorgungsspannung. Da die einwandfreie Funktion der Testabschaltung mittels der Meßeinrichtung überprüft und beim Auftreten eines Fehlers der elektrische Verbraucher abgeschaltet wird, kann trotz des zur Abschaltung der Hilfsversorgungsspannung vorgesehenen Halbleiterschaltelements eine hohe Abschaltsicherheit erreicht werden.

Bei einer besonders vorteilhaften Ausführungsform der Erfindung ist vorgesehen, daß die Abschalteinrichtungen zum Testabschalten der mit ihnen verbundenen Ansteuerschaltungen während einer Nichtansteuerungsphase der mit diesen Ansteuerschaltungen angesteuerbaren Halbleiterschalter, mit einer Synchronisationseinrichtung verbunden sind. Dadurch ist es möglich, das Abschalten der Hilfsversorgungsspannung zu testen, ohne den Betrieb des elektrischen Verbrauchers zu beeinträchtigen.

Vorteilhaft ist, wenn die Betriebsspannungsanschlüsse der Ansteuerschaltungen der am Pluspol des Zwischenkreises angeschlossenen Brückenzweige und die Betriebsspannungsanschlüsse der Ansteuerschaltungen der am Minuspol des Zwischenkreises angeschlossenen Brückenzweige jeweils mit einer gemeinsamen Abschalteinrichtung verbunden sind. Dadurch ergibt sich eine einfach aufgebaute Abschalteinrichtung. Die Abschaltung der Hilfsversorgungsspannung erfolgt mittels der Abschalteinrichtungen jeweils dann, wenn alle Halbleiterschalter der der Abschalteinrichtung jeweils zugeordneten Brückenzweige gleichzeitig nicht angesteuert werden und somit inaktiv sind.

Bei einer vorteilhaften Ausführungsform ist vorgesehen, daß die Synchronisationseinrichtung zur Detektion der Nichtansteuerungsphasen der mit der jeweiligen Abschalteinrichtung abzuschaltenden Halbleiterschalter eine Strommeßeinrichtung aufweist, zur Messung des Betriebsstromes wenigstens einer Ansteuerschaltung ausgebildet ist, und daß der Meßausgang dieser Strommeßeinrichtung mit einer Vergleichseinrichtung zum Vergleichen des Strommeßsignales mit einem Schwellwert verbunden ist. Da der Betriebsstrom der Ansteuerschaltung vom Schaltzustand der Ansteuerschaltung beziehungsweise des ihr nachgeschalteten Halbleiterschalters abhängig ist, ergibt sich bei durchgeschalteten Halbleiterschalter ein anderer Betriebsstrom als bei gesperrtem Halbleiterschalter. Die Nichtansteuerungsphase des Halbleiterschalters kann deshalb durch Auswerten des mittels der Strommeßeinrichtung gemessenen Betriebsstromverlaufs ermittelt werden. Dadurch kann die Testabschaltung der Hilfsversorgungsspannung jeweils während der Nichtansteuerungsphase des Halbleiterschalters erfolgen, ohne daß eine Synchronisationsleitung zwischen der das Steuersignal für den Halbleiterschalter erzeugenden Steuereinrichtung und der Abschalteinrichtung und/oder der Überwachungseinrichtung erforderlich ist.

Vorteilhaft ist, wenn die Abschalteinrichtungen für die Ansteuerschaltungen der in den mit den unterschiedlichen Polen verbundenen Brückenzweigen angeordneten Halbleiterschalter jeweils einen eigenen Mikrocomputer aufweisen und wenn diese Mikrocomputer zum gegenseitigen Datenaustausch über eine Datenverbindung miteinander verbunden sind. Die Mikrocomputer können die Durchführung des Tests dann gegenseitig überwachen, beispielsweise nach Art einer Watch-Dog-Funktion, wobei beim Auftreten eines Fehlers die Hilfsversorgungsspannung mittels der Abschalteinrichtung, in dessen Mikrocomputer der Fehler erkannt wurde, abgeschaltet wird.

Nachfolgend ist ein Ausführungsbeispiel der Erfindung anhand der Zeichnung näher erläutert. Es zeigen:
- Fig. 1: ein Teilschaltbild eines elektrischen Arbeitsgerätes, das einen über eine Halbleiterschalter aufweisende Brückenschaltung angesteuerten Elektromotor hat und
- Fig. 2: eine grafische Darstellung eines Dreieckssignales und der daraus abgeleiteten Steuersignale zum Ansteuern der Halbleiterschalter der in Fig.1 gezeigten Brückenschaltung, wobei die Zeit in Richtung des mit "t" bezeichneten Pfeils und rechtwinklig dazu jeweils der Signalpegel aufgetragen ist.

Ein im ganzen mit 1 bezeichnetes elektrisches Arbeitsgerät weist einen Gleichrichter 2 auf, dessen Eingangsanschlüsse 3 mit dem Wechselstromnetz verbunden sind und dessen Ausgangsanschlüsse jeweils mit einem Pol 4 eines Zwischenkreises 5 verbunden sind. Mittels des Gleichrichters 2 wird die Eingangswechselspannung beziehungsweise die Netzspannung in eine Zwischenkreisspannung gleichgerichtet, die an den Polen 4 des Zwischenkreises 5 anliegt. Der Zwischenkreis 5 ist über eine Brückenschaltung mit einem elektrischen Verbraucher 6, nämlich einem Elektromotor verbunden.

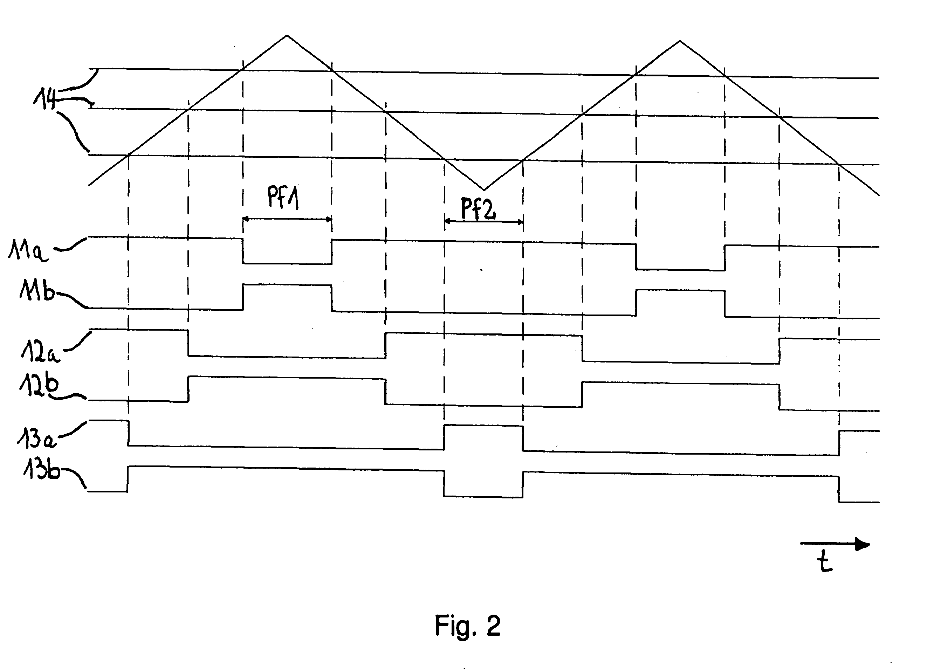

Die Brückenschaltung weist drei Halbbrücken auf, die jeweils einen ersten, in Fig. 2 oben angeordneten Brückenzweig 7a und einen zweiten, in Fig. 2 unten angeordneten Brückenzweig 7b haben. Die beiden Brückenzweige 7a, 7b jeder Halbbrücke sind jeweils mit einem ihrer Anschlüsse miteinander verbunden und mit ihrem anderen Anschluß an unterschiedlichen Polen 4 des Zwischenkreises 5 angeschlossen. Die Verbindungsstellen der Brückenzweige 7a und 7b bildenden Brückenmittelpunkte sind jeweils über Zuleitungen mit einem Anschluß der im Stern geschalteten Wicklungsstränge des Elektromotors 6 verbunden.

In jedem der Brückenzweige 7a, 7b ist ein als Transistor ausgebildeter Halbleiterschalter 8a, 8b angeordnet, dessen Kollektor-Emitter-Strecke in die Halbleiterbrücke geschaltet ist. Die Steuereingänge beziehungsweise Basisanschlüsse der Halbleiterschalter 8a, 8b sind jeweils über eine Ansteuerschaltung 9a, 9b an einem Steuersignalausgang einer Steuereinrichtung 10 angeschlossen. Mittels der Steuereinrichtung 10 werden pulsweitenmodulierte Steuersignale 11a, 11b, 12a, 12b, 13a, 13b für die Halbleiterschalter 8a, 8b erzeugt, die an den Steuersignalausgängen der Steuereinrichtung 10 anliegen.

In Fig. 2 sind die Signalverläufe der im wesentlichen als Rechtecksignale ausgebildeten Steuersignale 11a, 11b, 12a, 12b, 13a, 13b grafisch dargestellt. Dabei ist das Steuersignal des ersten Brückenzweigs 7a der ersten Halbbrücke mit 11a und dasjenige des zweiten Brückenzweigs 7b der ersten Halbbrücke mit 11b bezeichnet. In entsprechender Weise sind in Fig. 2 die Steuersignale der zweiten Halbbrücke mit 12a, 12b und diejenigen der dritten Halbbrücke mit 13a, 13b bezeichnet. Deutlich ist erkennbar, daß die Steuersignale des ersten Brückenzweigs 7a und zweiten Brückenzweigs 7b einer Halbbrücke jeweils invertiert zueinander sind, das heißt wenn der Halbleiterschalter 8a des ersten Brückenzweigs 7a einer Halbbrücke angesteuert beziehungsweise aktiv ist, ist gleichzeitig der Halbleiterschalter 8b des zweiten Brückenzweigs 7b derselben Halbbrücke jeweils nicht angesteuert beziehungsweise inaktiv.

Die Zeitpunkte, an denen die Steuersignale 11a, 11b, 12a, 12b, 13a, 13b ihre Signalpegel wechseln, sind in Fig. 2 jeweils strichliniert markiert. Die entsprechenden Zeitpunkte werden in der Steuereinrichtung 10 durch Vergleich des in Fig. 2 oben dargestellten Dreiecksignals mit Schwellwerten 14 ermittelt, die den Signalverlauf des Dreiecksignals schneiden.

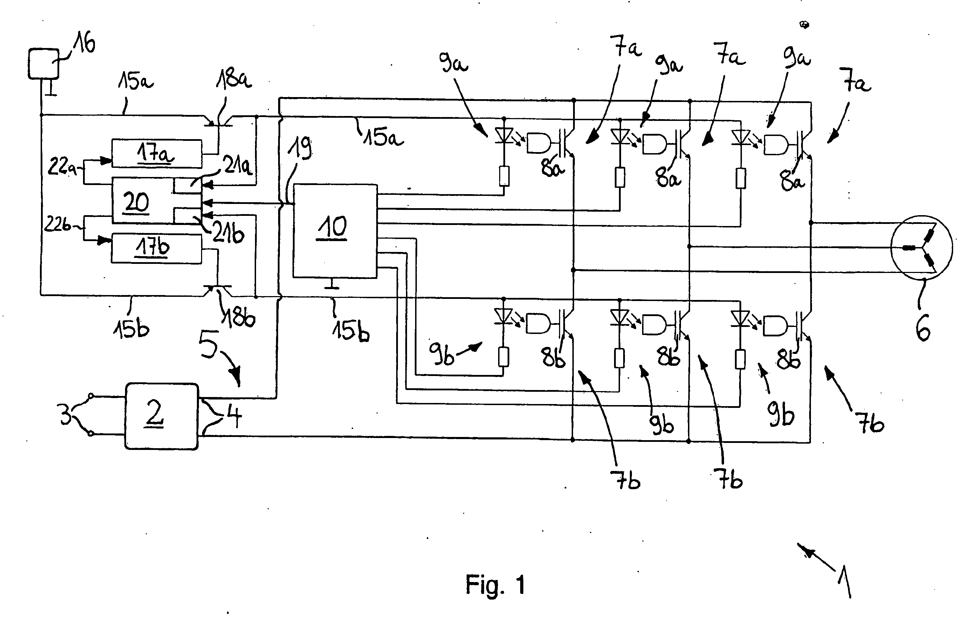

Die Ansteuerschaltungen 9a, 9b weisen jeweils einen Optokoppler auf, dessen einer Anschluß über eine Versorgungsleitung 15a, 15b mit Hilfsversorgungsspannungsquelle 16 und dessen anderer Anschluß mit dem ihm jeweils zugeordneten Steuersignalausgang der Steuereinrichtung 10 verbunden ist. In Fig. 1 ist erkennbar, daß die Ansteuerschaltungen 9a, 9b von Halbleiterschaltern 8a, 8b, die an demselben Pol 4 des Zwischenkreises angeschlossen sind, jeweils über eine gemeinsame Versorgungsleitung 15a, 15b mit der Hilfsversorgungsspannungsquelle 16 verbunden sind.

Die an den Ansteuerschaltungen 9a der ersten Brückenzweige 7a anliegende Hilfsversorgungsspannung 15a ist mittels einer ersten Abschalteinrichtung 17a und die an den Ansteuerschaltungen 9b der zweite Brückenzweige 7b anliegende Hilfsversorgungsspannung 15b ist mittels einer zweiten Abschalteinrichtung 17b abschaltbar. Die Abschalteinrichtungen 17a, 17b weisen jeweils ein in die Versorgungsleitung 15a, 15b geschaltetes Halbleiterschaltelement 18a, 18b auf. Bei dem Ausführungsbeispiel nach Fig. 1 sind die Halbleiterschaltelemente 18a, 18b Transistoren.

Mittels der Abschalteinrichtung 17a wird während einer Nichtansteuerungsphase, in der keiner der in den ersten Brückenzweigen 7a angeordneten Halbleiterschalter 8a durch eines der Steuersignale 11a, 12a, 13a angesteuert wird, eine Testabschaltung der an der Ansteuerschaltung 9a anliegenden Hilfsversorgungsspannung durchgeführt. In Fig. 2 ist eine Nichtansteuerungsphase der Halbleiterschalter 8a durch den Doppelpfeil Pf1 markiert. Die Synchronistion der Testabschaltung mit den Nichtansteuerungsphasen erfolgt über eine Synchronisationsleitung 19, welche die Steuereinrichtung 10 mit einer die Testabschaltung auslösenden Überwachungseinrichtung 20 verbindet.

Während der Testabschaltung wird die elektrische Spannung an dem mit der Versorgungsleitung 15a verbundenen Anschluß der Ansteuerschaltung 9a mittels einer mit der Versorgungsleitung 15a verbunden Meßeinrichtung 21a gemessen. Die auf diese Weise ermittelten Meßwerte für die elektrische Spannung werden an die mit der Meßeinrichtung 21a verbundene Überwachungseinrichtung 20 weitergeleitet und dort mit einem vorgegebenen Grenzwert verglichen. Falls dieser Grenzwert beispielsweise aufgrund eines Defekts des Halbleiterschaltelements 18a überschritten werden sollte, wird ein Fehler erkannt und die an der zweiten Ansteuerschaltung 9b anliegende Hilfsversorgungsspannung wird mittels der zweiten Abschalteinrichtung 17b abgeschaltet. Die Abschalteinrichtung 17b ist dazu über eine Steuerleitung 22a mit der Überwachungseinrichtung 20 verbunden. Die Ansteuerschaltungen 9a, 9b werden durch das Abschalten der Hilfsversorgungsspannung inaktiv, so daß die zweiten Halbleiterschalter 8b sperren. Dadurch wird der Stromfluß in dem Antriebsmotor 6 mit großer Sicherheit unterbrochen, selbst dann, wenn ein oder mehrere der ersten Halbleiterschalter 8a leitend sein sollte(n). Aber auch dann, wenn zusätzlich noch einer oder mehrere der Halbleiterschalter 8b einen Defekt aufweisen sollten, wird verhindert, daß sich in dem Antriebsmotor ein Drehfeld ausbildet.

In entsprechender Weise wird mittels der Abschalteinrichtung 17b während einer Nichtansteuerungsphase, in der keiner der in den zweiten Brückenzweigen 7b angeordneten Halbleiterschalter 8b durch eines der Steuersignale 11b, 12b, 13b angesteuert wird, eine Testabschaltung der an der Ansteuerschaltung 9b anliegenden Hilfsversorgungsspannung durchgeführt. In Fig. 2 ist eine Nichtansteuerungsphase der Halbleiterschalter 8b durch den Doppelpfeil Pf2 markiert. Während der Testabschaltung wird die elektrische Spannung an dem mit der Versorgungsleitung 15b verbundenen Anschluß der Ansteuerschaltung 9b mittels einer mit der Versorgungsleitung 15b verbundenen Meßeinrichtung 21b gemessen. Die Meßwerte für die elektrische Spannung werden an die mit der Meßeinrichtung 21b verbundene Überwachungseinrichtung 20 weitergeleitet und dort mit einem vorgegebenen Grenzwert verglichen. Falls dieser Grenzwert überschritten wird, wird ein Fehler erkannt und die an der ersten Ansteuerschaltung 9a anliegende Hilfsversorgungsspannung 15a wird über die Steuerleitung 22b und die erste Abschalteinrichtung 17a abgeschaltet.

Die Testabschaltung der an den Ansteuerschaltungen 9a, 9b anliegenden Hilfsversorgungsspannungen wird zyklisch wiederholt, beispielsweise alle acht Stunden, wie im Positionspapier DKE-AK 226.03 vorgeschrieben.

Bei dem Verfahren zum Betreiben des elektrischen Arbeitsgerätes 1 wird also ein elektrischer Verbraucher 6 aus einem Wechselstromnetz gespeist, indem die Eingangswechselspannung gleichgerichtet und die so erhaltene Zwischenkreisspannung an die Halbbrücken einer Brückenschaltung angelegt wird. Jede der Halbbrücken weist zwei Brückenzweige 7a, 7b auf, in denen jeweils wenigstens ein Halbleiterschalter 8a, 8b angeordnet ist, an den über eine aus einer Hilfsversorgungsspannungsquelle 16 gespeiste Ansteuerschaltung 9a, 9b Steuersignale angelegt werden. Bei jedem der jeweils an einem der Pole 4 der Zwischenkreisspannung 5 angeschlossenen Brückenzweige wird während einer Nichtansteuerungsphase des in dem betreffenden Brückenzweig angeordneten Halbleiterschalters 8a, 8b eine Testabschaltung der an der Ansteuerschaltung 9a, 9b dieses Halbleiterschalters 8a, 8b anliegenden Hilfsversorgungsspannung durchgeführt. Diese Testabschaltung wird durch eine Messung überwacht und beim Auftreten eines Fehlers bei der Abschaltung der Hilfsversorgungsspannung werden zumindest die an den Ansteuerschaltungen 9a, 9b der an dem anderen Pol der Zwischenkreisspannung angeschlossenen Brückenzweige 7a, 7b der Halbbrücken anliegenden Hilfsversorgungsspannungen abgeschaltet.

## Patentansprüche

1. Verfahren zum Betreiben eines elektrischen Arbeitsgerätes (1), insbesondere eines elektromotorischen Antriebs, wobei ein elektrischer Verbraucher (6) aus einem Wechselstromnetz gespeist wird, indem die Eingangswechselspannung gleichgerichtet und die so erhaltene Zwischenkreisspannung an eine Brückenschaltung angelegt wird, wobei die Brückenschaltung zwei Halbbrücken mit jeweils zwei Brückenzweigen (7a, 7b) aufweist, wobei in jedem Brückenzweig (7a, 7b) jeweils wenigstens ein Halbleiterschalter (8a, 8b) angeordnet ist, an den über eine Ansteuerschaltung (9a, 9b) Steuersignale angelegt werden und die Ansteuerschaltung (9a, 9b) aus einer Hilfsversorgungsspannungsquelle (16) gespeist wird, **dadurch gekennzeichnet, dass** die Brückenzweige (7a, 7b) jeweils mit unterschiedlichen Polen des Zwischenkreises (5) verbunden sind, dass jedem Brückenzweig (7a, 7b) eine Abschalteinrichtung (17a, 17b) zugeordnet ist, über die die Betriebsspannungsanschlüsse der Ansteuerschaltungen (9a, 9b) des jeweiligen Brückenzweigs (7a, 7b) mit der Hilfsversorgungsspannungsquelle (16) verbunden werden, daß in jedem Brückenzweig (7a, 7b) durch die Abschalteinrichtungen (17a, 17b) eine Testabschaltung der an den Ansteuerschaltungen (9a, 9b) anliegenden Hilfsversorgungsspannung (16) durchgeführt wird, daß diese Testabschaltung zum Erkennen eines Fehlers durch eine Messung überwacht wird, und daß beim Auftreten eines Fehlers bei einer Testabschaltung der Hilfsversorgungsspannung (16) der Ansteuerschaltungen (9a, 9b) durch die Abschalteinrichtung (17a, 17b) eines Brückenzweigs (7a, 7b) zumindest die Hilfsversorgungsspannung (16) der Ansteuerschaltungen (9a, 9b) des anderen Brückenzweigs (7a, 7b) durch die andere Abschalteinrichtung (17a, 17b) abgeschaltet wird.

2. Verfahren nach Anspruch 1, **dadurch gekennzeichnet, daß** die Testabschaltung während einer Nichtansteuerungsphase der in dem abzuschaltenden Brückenzweig (7a, 7b) angeordneten Halbleiterschalter (8a, 8b) durchgeführt wird.

3. Verfahren nach Anspruch 1 oder 2, **dadurch gekennzeichnet, daß** bei an demselben Pol (4) der Zwischenkreisspannung angeschlossenen Brückenzweigen (7a, 7b) die Testabschaltung der an den Ansteuerschaltungen (9a, 9b) der in diesen Brückenzweigen (7a, 7b) angeordneten Halbleiterschalter (8a, 8b) anliegenden Hilfsversorgungsspannungen gleichzeitig durchgeführt wird.

4. Verfahren nach einem der Ansprüche 1 bis 3, **dadurch gekennzeichnet, daß** zur Synchronisation der Testabschaltungen der an den Ansteuerschaltungen (9a, 9b) anliegenden Hilfsversorgungsspannungen mit den an die Halbleiterschalter (8a, 8b) angelegten Steuersignalen (11a, 11b, 12a, 12b, 13a, 13b) der zeitliche Verlauf der Stromaufnahme wenigstens einer Ansteuerschaltung (9a, 9b) gemessen und mit einem Schwellwert verglichen wird.

5. Verfahren nach einem der Ansprüche 1 bis 4, **dadurch gekennzeichnet, daß** die Steuerung der Testabschaltungen mittels eines Mikrocomputers erfolgt und daß vorzugsweise für jeden Halbleiterschalter (8a, 8b) oder für jede Gruppe von Halbleiterschaltern (8a, 8b), bei den die Testabschaltung gleichzeitig durchgeführt wird, jeweils ein eigener Mikrocomputer vorgesehen ist, und daß sich die Mikrocomputer gegebenenfalls gegenseitig überwachen, wobei beim Auftreten eines Fehlers zumindest die an den Ansteuerschaltungen der an einem der Pole (4) der Zwischenkreisspannung angeschlossenen Brückenzweige (7a, 7b) anliegenden Hilfsversorgungsspannungen abgeschaltet werden.

6. Elektrisches Arbeitsgerät (1), insbesondere elektromotorischer Antrieb, mit einem über einen Frequenzumrichter mit dem Wechselstromnetz verbundenen elektrischen Verbraucher (6), wobei der Frequenzumrichter einen über einen Gleichrichter (2) an dem Wechselstromnetz angeschlossenen Zwischenkreis (5) aufweist, der über eine Brückenschaltung mit dem elektrischen Verbraucher (6) verbunden ist, wobei die Brückenschaltung wenigstens zwei Halbbrücken mit jeweils zwei Brückenzweigen (7a, 7b) aufweist, in denen jeweils wenigstens ein Halbleiterschalter (8a, 8b) angeordnet ist, wobei die Halbleiterschalter (8a, 8b) jeweils über eine Ansteuerschaltung (9a, 9b) an einem Steuersignalausgang einer Steuereinrichtung (10) angeschlossen sind, und wobei die Betriebsspannungsanschlüsse der Ansteuerschaltungen (9a, 9b) mit einer Hilfsversorgungsspannungsquelle (16) verbunden sind, **dadurch gekennzeichnet, dass** die Brückenzweige (7a, 7b) jeweils mit unterschiedlichen Polen des Zwischenkreises (5) verbunden sind, dass jedem Brückenzweig (7a, 7b) eine Abschalteinrichtung (17a, 17b) zugeordnet ist, über die die Betriebsspannungsanschlüsse der Ansteuerschaltungen (9a, 9b) des jeweiligen Brückenzweigs (7a, 7b) mit der Hilfsversorgungsspannungsquelle (16) verbunden sind, dass die Abschalteinrichtungen (17a, 17b) jeweils wenigstens ein Halbleiterschaltelement (18a, 18b) aufweisen, dass diesen Halbleiterschaltelementen (18a, 18b) eine Messeinrichtung (21a, 21b) nachgeschaltet ist, welche mit einer Überwachungseinrichtung (20) verbunden ist, wobei die Messeinrichtung (21a, 21b) derart ausgebildet ist, dass sie eine Testabschaltung der Hilfsversorgungsspannung (16) der Ansteuerschaltungen (9a, 9b) durch die Abschalteinrichtung (17a, 17b) eines Brückenzweiges durch eine Messung überwacht, dass die Abschalteinrichtungen (17a, 17b) jeweils einen Steuereingang zum Schalten des Halbleiterschaltelements (18a, 18b) aufweisen und diese Steuereingänge mit Ausgängen der Überwachungseinrichtung (20) verbunden sind und, dass die Überwachungseinrichtung (20) derart ausgebildet ist, dass sie aus dem Messergebnis der Messeinrichtung (21a, 21b) einen Fehler bei der Testabschaltung der Hilfsversorgungsspannung (16) der Ansteuerschaltungen (9a, 9b) durch die Abschalteinrichtung (17a, 17b) eines Brückenzweigs (7a, 7b) erkennen kann und dass sie beim Auftreten eines solchen Fehlers zumindest die Hilfsversorgungsspannung (16) der Ansteuerschaltungen (9a, 9b) des anderen Brückenzweigs (7a, 7b) durch die andere Abschalteinrichtung (17a, 17b) abschaltet.

7. Elektrisches Arbeitsgerät nach Anspruch 6, **dadurch gekennzeichnet, daß** die Abschalteinrichtungen (17a, 17b) zum Testabschalten der mit ihnen verbundenen Ansteuerschaltungen (9a, 9b) während einer Nichtansteuerungsphase der mit diesen Ansteuerschaltungen (9a, 9b) angesteuerbaren Halbleiterschalter (8a, 8b) mit einer Synchronisationseinrichtung verbunden sind.

8. Elektrisches Arbeitsgerät nach Anspruch 6 oder 7,
**dadurch gekennzeichnet, daß** die Betriebsspannungsanschlüsse der Ansteuerschaltungen (9a, 9b) der am Pluspol des Zwischenkreises (5) angeschlossenen Brückenzweige (7a, 7b) und die Betriebsspannungsanschlüsse der Ansteuerschaltungen der am Minuspol des Zwischenkreises (5) angeschlossenen Brückenzweige (7a, 7b) jeweils mit einer gemeinsamen Abschalteinrichtung (17a, 17b) verbunden sind.

9. Elektrisches Arbeitsgerät nach einem der Ansprüche 6 bis 8, **dadurch gekennzeichnet, daß** die Synchronisationseinrichtung zur Detektion der Nichtansteuerungsphasen der mit der jeweiligen Abschalteinrichtung (17a, 17b) abzuschaltenden Halbleiterschalter (8a, 8b) eine Strommeßeinrichtung aufweist, die zur Messung des Betriebsstromes wenigstens einer Ansteuerschaltung (9a, 9b) ausgebildet ist, und dass der Meßausgang dieser Strommeßeinrichtung mit einer Vergleichseinrichtung zum Vergleichen des Strommeßsignales mit einem Schwellwert verbunden ist.

10. Elektrisches Arbeitsgerät nach einem der Ansprüche 6 bis 9, **dadurch gekennzeichnet, dass** die Abschalteinrichtungen (17a, 17b) jeweils einen eigenen Mikrocomputer aufweisen und dass diese Mikrocomputer zum gegenseitigen Datenaustausch über eine Datenverbindung miteinander verbunden sind.

## Claims

1. Method for operating an electrical working device (1), in particular an electromotive drive, an electrical load (6) being supplied from an AC system by virtue of the AC input voltage being rectified and the intermediate circuit voltage obtained in this manner being applied to a bridge circuit, the bridge circuit having two half-bridges each having two bridge paths (7a, 7b), at least one semiconductor switch (8a, 8b) to which control signals are applied via a drive circuit (9a, 9b) being respectively arranged in each bridge path (7a, 7b), and the drive circuit (9a, 9b) being supplied from an auxiliary supply voltage source (16), **characterized in that** the bridge paths (7a, 7b) are each connected to different poles of the intermediate circuit (5), **in that** each bridge path (7a, 7b) is assigned a disconnection device (17a, 17b) which is used to connect the operating voltage connections of the drive circuits (9a, 9b) in the respective bridge path (7a, 7b) to the auxiliary supply voltage source (16), **in that** a test disconnection of the auxiliary supply voltage (16) applied to the drive circuits (9a, 9b) is carried out by the disconnection devices (17a, 17b) in each bridge path (7a, 7b), **in that** this test disconnection is monitored by means of a measurement in order to detect a fault, and **in that**, when a fault occurs during a test disconnection of the auxiliary supply voltage (16) of the drive circuits (9a, 9b) by the disconnection device (17a, 17b) in one bridge path (7a, 7b), at least the auxiliary supply voltage (16) of the drive circuits (9a, 9b) in the other bridge path (7a, 7b) is disconnected by the other disconnection device (17a, 17b).

2. Method according to Claim 1, **characterized in that** the test disconnection is carried out during a non-driving phase of the semiconductor switches (8a, 8b) arranged in the bridge path (7a, 7b) to be disconnected.

3. Method according to Claim 1 or 2, **characterized in that**, in the case of bridge paths (7a, 7b) which are connected to the same pole (4) of the intermediate circuit voltage, the test disconnection of the auxiliary supply voltages applied to the drive circuits (9a, 9b) of the semiconductor switches (8a, 8b) arranged in these bridge paths (7a, 7b) is carried out simultaneously.

4. Method according to one of Claims 1 to 3,
**characterized in that**, in order to synchronize the test disconnections of the auxiliary supply voltages applied to the drive circuits (9a, 9b) with the control signals (11a, 11b, 12a, 12b, 13a, 13b) applied to the semiconductor switches (8a, 8b), the temporal profile of the current draw of at least one drive circuit (9a, 9b) is measured and compared with a threshold value.

5. Method according to one of Claims 1 to 4,
**characterized in that** the test disconnections are controlled by means of a microcomputer, and **in that** a separate microcomputer is respectively provided preferably for each semiconductor switch (8a, 8b) or for each group of semiconductor switches (8a, 8b) in which the test disconnection is carried out simultaneously, and **in that** the microcomputers optionally monitor one another, at least the auxiliary supply voltages applied to the drive circuits in the bridge paths (7a, 7b) connected to one of the poles (4) of the intermediate circuit voltage being disconnected when a fault occurs.

6. Electrical working device (1), in particular electromotive drive, having an electrical load (6) which is connected to the AC system via a frequency converter, the frequency converter having an intermediate circuit (5) which is connected to the AC system via a rectifier (2) and is connected to the electrical load (6) via a bridge circuit, the bridge circuit having at least two half-bridges each having two bridge paths (7a, 7b) in which at least one semiconductor switch (8a, 8b) is respectively arranged, the semiconductor switches (8a, 8b) each being connected to a control signal output of a control device (10) via a drive circuit (9a, 9b), and the operating voltage connections of the drive circuits (9a, 9b) being connected to an auxiliary supply voltage source (16), **characterized in that** the bridge paths (7a, 7b) are each connected to different poles of the intermediate circuit (5), **in that** each bridge path (7a, 7b) is assigned a disconnection device (17a, 17b) which is used to connect the operating voltage connections of the drive circuits (9a, 9b) in the respective bridge path (7a, 7b) to the auxiliary supply voltage source (16), **in that** the disconnection devices (17a, 17b) each have at least one semiconductor switching element (18a, 18b), **in that** a measuring device (21a, 21b) which is connected to a monitoring device (20) is connected downstream of these semiconductor switching elements (18a, 18b), the measuring device (21a, 21b) being designed in such a manner that it monitors a test disconnection of the auxiliary supply voltage (16) of the drive circuits (9a, 9b) by the disconnection device (17a, 17b) in one bridge path by means of a measurement, **in that** the disconnection devices (17a, 17b) each have a control input for switching the semiconductor switching element (18a, 18b) and these control inputs are connected to outputs of the monitoring device (20), and **in that** the monitoring device (20) is designed in such a manner that it can use the measurement result from the measuring device (21a, 21b) to detect a fault in the test disconnection of the auxiliary supply voltage (16) of the drive circuits (9a, 9b) by the disconnection device (17a, 17b) in one bridge path (7a, 7b) and in such a manner that it disconnects at least the auxiliary supply voltage (16) of the drive circuits (9a, 9b) in the other bridge path (7a, 7b) by means of the other disconnection device (17a, 17b) when such a fault occurs.

7. Electrical working device according to Claim 6, **characterized in that** the disconnection devices (17a, 17b), for the test disconnection of the drive circuits (9a, 9b) connected to them during a non-driving phase of the semiconductor switches (8a, 8b) which can be driven using these drive circuits (9a, 9b), are connected to a synchronization device.

8. Electrical working device according to Claim 6 or 7, **characterized in that** the operating voltage connections of the drive circuits (9a, 9b) in the bridge paths (7a, 7b) connected to the positive pole of the intermediate circuit (5) and the operating voltage connections of the drive circuits in the bridge paths (7a, 7b) connected to the negative pole of the intermediate circuit (5) are each connected to a common disconnection device (17a, 17b).

9. Electrical working device according to one of Claims 6 to 8, **characterized in that**, in order to detect the non-driving phases of the semiconductor switches (8a, 8b) to be disconnected using the respective disconnection device (17a, 17b), the synchronization device has a current measuring device which is designed to measure the operating current of at least one drive circuit (9a, 9b), and **in that** the measuring output of this current measuring device is connected to a comparison device for comparing the current measurement signal with a threshold value.

10. Electrical working device according to one of Claims 6 to 9, **characterized in that** the disconnection devices (17a, 17b) each have a separate microcomputer, and **in that** these microcomputers are connected to one another via a data connection for the purpose of interchanging data with one another.

## Revendications

1. Procédé d'utilisation d'un appareil de travail électrique (1), notamment d'un entraînement électromotorisé, dans lequel un consommateur électrique (6) est alimenté depuis un réseau de courant alternatif en redressant la tension alternative d'entrée et en appliquant la tension de circuit intermédiaire ainsi obtenue à un circuit en pont, le circuit en pont présentant deux demi-ponts ayant chacun deux branches de pont (7a, 7b), au moins un commutateur semi-conducteur (8a, 8b) auquel des signaux de commande sont appliqués via un circuit d'amorçage (9a, 9b) étant respectivement disposé dans chaque branche de pont (7a, 7b) et le circuit d'amorçage (9a, 9b) étant alimenté depuis une source de tension d'alimentation auxiliaire (16), **caractérisé en ce que** les branches de pont (7a, 7b) sont reliées respectivement à des pôles différents du circuit intermédiaire (5), qu'à chaque branche de pont (7a, 7b) est associé un dispositif de désactivation (17a, 17b) par lequel les raccordements de tension de service des circuits d'amorçage (9a, 9b) de la branche de pont respective (7a, 7b) sont reliés à la source de tension d'alimentation auxiliaire (16), que, dans chaque branche de pont (7a, 7b), un test de désactivation de la tension d'alimentation auxiliaire (16) appliquée aux circuits d'amorçage (9a, 9b) est réalisé par le biais des dispositifs de désactivation (17a, 17b), que ce test de désactivation est surveillé par une mesure pour détecter toute erreur et que, en cas de survenance d'une erreur lors d'un test de désactivation de la tension d'alimentation auxiliaire (16) des circuits d'amorçage (9a, 9b) par le dispositif de désactivation (17a, 17b) d'une branche de pont (7a, 7b), au moins la tension d'alimentation auxiliaire (16) des circuits d'amorçage (9a, 9b) de l'autre branche de pont (7a, 7b) est désactivée par l'autre dispositif de désactivation (17a, 17b).

2. Procédé selon la revendication 1, **caractérisé en ce que** le test de désactivation est réalisé pendant une phase de non-amorçage des commutateurs semi-conducteurs (8a, 8b) disposés dans la branche de pont (7a, 7b) à désactiver.

3. Procédé selon la revendication 1 ou 2, **caractérisé en ce que**, dans le cas de branches de pont (7a, 7b) raccordées au même pôle (4) de la tension de circuit intermédiaire, le test de désactivation des tensions d'alimentation auxiliaires appliquées aux circuits d'amorçage (9a, 9b) des commutateurs semi-conducteurs (8a, 8b) disposés dans ces branches de pont (7a, 7b) est réalisé simultanément.

4. Procédé selon l'une quelconque des revendications 1 à 3, **caractérisé en ce que**, pour la synchronisation des tests de désactivation des tensions d'alimentation auxiliaires appliquées aux circuits d'amorçage (9a, 9b) avec les signaux de commande (11a, 11b, 12a, 12b, 13a, 13b) appliqués aux commutateurs semi-conducteurs (8a, 8b), l'évolution chronologique de la consommation de courant d'au moins un circuit d'amorçage (9a, 9b) est mesurée et comparée à une valeur seuil.

5. Procédé selon l'une quelconque des revendications 1 à 4, **caractérisé en ce que** la commande des tests de désactivation se fait au moyen d'un micro-ordinateur et que, de préférence pour chaque commutateur semi-conducteur (8a, 8b) ou pour chaque groupe de commutateurs semi-conducteurs (8a, 8b) pour lesquels le test de désactivation est réalisé simultanément, il est prévu respectivement un micro-ordinateur propre et que les micro-ordinateurs se surveillent le cas échéant mutuellement, sachant que, en cas de survenance d'une erreur, au moins les tensions d'alimentation auxiliaires appliquées aux circuits d'amorçage des branches de pont (7a, 7b) raccordées à un des pôles (4) de la tension de circuit intermédiaire sont désactivées.

6. Appareil de travail électrique (1), notamment un entraînement électromotorisé, comportant un consommateur électrique (6) relié au réseau de courant alternatif par le biais d'un convertisseur de fréquence, le convertisseur de fréquence présentant un circuit intermédiaire (5) raccordé au réseau de courant alternatif au moyen d'un redresseur (2) et relié par un circuit en pont au consommateur électrique (6), le circuit en pont présentant au moins deux demi-ponts ayant chacun deux branches de pont (7a, 7b), dans lesquelles est disposé respectivement au moins un commutateur semi-conducteur (8a, 8b), les commutateurs semi-conducteurs (8a, 8b) étant raccordés respectivement par un dispositif d'amorçage (9a, 9b) à une sortie de signaux de commande d'un dispositif de commande (10) et les raccordements de tension de service des circuits d'amorçage (9a, 9b) étant raccordés à une source de tension d'alimentation auxiliaire (16), **caractérisé en ce que** les branches de pont (7a, 7b) sont reliées respectivement à des pôles différents du circuit intermédiaire (5), qu'à chaque branche de pont (7a, 7b) est associé un dispositif de désactivation (17a, 17b) par lequel les raccordements de tension de service des circuits d'amorçage (9a, 9b) de la branche de pont respective (7a, 7b) sont reliés à la source de tension d'alimentation auxiliaire (16), que les dispositifs de désactivation (17a, 17b) présentent respectivement au moins un élément de commutation semi-conducteur (18a, 18b), qu'en aval de ces éléments de commutation semi-conducteurs (18a, 18b) est installé un dispositif de mesure (21a, 21b) qui est raccordé à un dispositif de surveillance (20), le dispositif de mesure (21a, 21b) étant conçu de manière à ce qu'il surveille un test de désactivation de la tension d'alimentation auxiliaire (16) des circuits d'amorçage (9a, 9b) par le dispositif de désactivation (17a, 17b) d'une branche de pont par une mesure, que les dispositifs de désactivation (17a, 17b) présentent respectivement une entrée de commande pour mettre en circuit l'élément de commutation semi-conducteur (18a, 18b) et que ces entrées de commande sont raccordées à des sorties du dispositif de surveillance (20), que le dispositif de surveillance (20) est réalisé de manière à pouvoir, à partir du résultat de mesure du dispositif de mesure (21a, 21b), détecter une erreur lors du test de désactivation de la tension d'alimentation auxiliaire (16) des circuits d'amorçage (9a, 9b) par le dispositif de désactivation (17a, 17b) d'une branche de pont (7a, 7b) et que, en cas de survenance d'une telle erreur, il désactive au moins la tension d'alimentation auxiliaire (16) des circuits d'amorçage (9a, 9b) de l'autre branche de pont (7a, 7b) par l'autre dispositif de désactivation (17a, 17b).

7. Appareil de travail électrique selon la revendication 6, **caractérisé en ce que** les dispositifs de désactivation (17a, 17b) permettant le test de désactivation des circuits d'amorçage (9a, 9b) qui leur sont raccordés pendant une phase de non-amorçage des commutateurs semi-conducteurs (8a, 8b) pouvant être amorcés par ces circuits d'amorçage (9a, 9b) sont raccordés à un dispositif de synchronisation.

8. Appareil de travail électrique selon la revendication 6 ou 7, **caractérisé en ce que** les raccordements de tension de service des circuits d'amorçage (9a, 9b) des branches de pont (7a, 7b) raccordées au pôle plus du circuit intermédiaire (5) et les raccordements de tension de service des circuits d'amorçage des branches de pont (7a, 7b) raccordées au pôle moins du circuit intermédiaire (5) sont reliés respectivement à un dispositif de désactivation commun (17a, 17b).

9. Appareil de travail électrique selon l'une quelconque des revendications 6 à 8, **caractérisé en ce que** le dispositif de synchronisation permettant la détection des phases de non-amorçage des commutateurs semi-conducteurs (8a, 8b) à désactiver à l'aide du dispositif de désactivation respectif (17a, 17b) présente un dispositif de mesure de courant, qui est conçu pour mesurer le courant de service d'au moins un circuit d'amorçage (9a, 9b) et que la sortie de mesure de ce dispositif de mesure de courant est raccordée à un dispositif comparateur permettant de comparer le signal de mesure de courant à une valeur seuil.

10. Appareil de travail électrique selon l'une quelconque des revendications 6 à 9, **caractérisé en ce que** les dispositifs de désactivation (17a, 17b) présentent respectivement un micro-ordinateur propre et que ces micro-ordinateurs sont raccordés entre eux pour échanger mutuellement des données via une connexion de transfert de données.
